Europäisches Patentamt

European Patent Office

Office européen des brevets

(19)

(11) EP 0 633 577 B1

(12) FASCICULE DE BREVET EUROPEEN

(45) Date de publication et mention
de la délivrance du brevet:
**27.10.1999 Bulletin 1999/43**

(51) Int Cl.⁶: **G11C 19/28**, G11C 27/04

(21) Numéro de dépôt: **94401510.6**

(22) Date de dépôt: **01.07.1994**

(54) **Convertisseur charge-tension à rétroaction commandée**

Retroaktiv gesteuerter Ladungs-Spannungsumsetzer

Retroactively controlled charge-voltage convertor

(84) Etats contractants désignés:
**BE CH DE FR GB IT LI NL**

(30) Priorité: **09.07.1993 FR 9308468**

(43) Date de publication de la demande:
**11.01.1995 Bulletin 1995/02**

(73) Titulaire: **THOMSON-CSF SEMICONDUCTEURS
SPECIFIQUES
75008 Paris (FR)**

(72) Inventeur: **Cortiula, Jean-Alain, Thomson-CSF
F-92402 Courbevoie Cedex (FR)**

(74) Mandataire: **Guérin, Michel et al
Thomson-CSF Propriété Intellectuelle,
13, Avenue du Président Salvador Allende
94117 Arcueil Cédex (FR)**

(56) Documents cités:
**EP-A- 0 069 072        EP-A- 0 495 500**

- **PATENT ABSTRACTS OF JAPAN vol. 16, no. 138
(E-1186) 7 Avril 1992 & JP-A-03 297 287
(HITACHI)**
- **PATENT ABSTRACTS OF JAPAN vol. 8, no. 250
(E-279) 16 Novembre 1984 & JP-A-59 126 379
(NIPPON DENKI K.K.)**

## Description

La présente invention concerne un convertisseur charge-tension.

Les convertisseurs charge-tension sont utilisés, par exemple, dans les dispositifs à transfert de charges.

Un convertisseur charge-tension est constitué d'une diode de lecture et d'un amplificateur de lecture. La diode de lecture présente une capacité de diffusion $C_d$ et l'amplificateur un gain G. Comme cela est connu de l'homme de l'art le convertisseur charge-tension est principalement caractérisé par une grandeur appelée facteur de conversion qui relie la tension de sortie du convertisseur à la charge recueillie.

Un tel convertisseur est décrit dans le document de brevet EP-A-0 495 500.

La valeur théorique du facteur de conversion est donnée par la formule $F_c = \dfrac{G}{C_d}$.

Du fait de la présence de capacités parasites qui interviennent en parallèle de la capacité de diffusion $C_d$ (capacité $C_r$ de recouvrement de la diode, capacité Miller ramenée à l'entrée $C_m$ de l'amplificateur) le facteur de conversion s'écrit :

$$F_c = \frac{G}{C_d + C_r + C_m}$$

Selon l'art antérieur le gain G est ajusté à l'aide d'une résistance R extérieure au composant que constitue le dispositif à transfert de charges. Cette résistance fixe le gain, la bande passante et le bruit de la chaîne de lecture, qui comprend, outre le convertisseur charge-tension, un autre amplificateur suivi d'un filtre passe-bas, lequel est suivi d'un échantillonneur double corrélé.

Un tel dispositif présente de nombreux inconvénients.

En particulier, du fait du mauvais gain de l'étage de conversion, la chaîne complète de lecture présente des performances de bruit non optimales puisque l'essentiel de l'amplification est effectué après l'amplificateur de lecture. Ceci est très pénalisant en particulier pour les applications traitant des signaux de faible amplitude.

L'invention ne présente pas ces inconvénients.

La présente invention a pour objet un dispositif de conversion charge-tension comprenant une diode de lecture et un amplificateur de lecture, l'amplificateur de lecture comprenant un transistor dont la grille est connectée à la diode de lecture et dont la source constitue le point où est recueillie la tension de sortie du dispositif, ledit transistor assurant un gain à vide Go entre la tension recueillie sur sa grille et la tension recueillie sur sa source, dans lequel l'amplificateur de lecture comprend des moyens supplémentaires permettant de lui assurer un gain G supérieur à Go lors des phases de lecture.

Comme cela sera décrit ultérieurement, les moyens supplémentaires sont constitués d'un générateur de courant piloté par un amplificateur.

Plus précisément, l'objet de l'invention tel que défini dans la revendication 1, est un dispositif de conversion charge-tension comprenant une diode de lecture (D) aux bornes de laquelle apparaît la tension Vd et un transistor de lecture (T2), de gain à vide Go, dont la grille est reliée à la diode de lecture de façon que soit appliquée à ladite grille ladite tension Vd et dont la source constitue le point (A) où est recueillie la tension de sortie Vs dudit dispositif, ladite conversion s'effectuant en trois temps, un premier temps (t1) durant lequel est effectué la pré-charge de la capacité (Cd) de la diode (D), un deuxième temps ($t_2$) durant lequel la diode est à un potentiel flottant et un troisième temps ($t_3$) pendant lequel le signal issu de la conversion charge-tension est lu, caractérisé en ce qu'il comprend un amplificateur (4) à gain contrôlé K, et un transistor (T3) monté en inverseur, de gain à vide égal à -G1, ledit amplificateur de gain K ayant son entrée reliée au point (A) où est recueillie la tension de sortie Vs et sa sortie reliée à la grille du transistor (T3) monté en inverseur, ce dernier ayant son drain relié à l'amplificateur de gain K et sa source reliée à une masse de façon que le gain G vérifie l'équation :

$$G = \frac{Go}{1 + G1K},$$

l'amplificateur de gain K étant associé à des circuits de commande de gain permettant au gain K de prendre une valeur négative pendant les deuxième et troisième temps (t2, t3) de façon que le gain G soit supérieur à Go, et une valeur positive durant le premier temps (t1) de façon que le gain G soit sensiblement égal à zéro pendant ce premier temps.

Un avantage de l'invention est donc de réduire le facteur de bruit de la chaîne de lecture.

D'autres caractéristiques et avantages de l'invention apparaîtront à la lecture d'un mode de réalisation préférentiel fait avec référence aux figures ci-annexées dans lesquelles :

- La figure 1 représente un convertisseur charge tension et sa chaîne de lecture selon l'art antérieur.

- La figure 2 représente, en fonction du temps, la tension détectée par le convertisseur charge-tension selon l'art antérieur.

- La figure 3 représente un convertisseur charge tension selon le mode de réalisation préférentiel de l'invention.

- La figure 4 représente la tension détectée en fonction du temps par le convertisseur charge-tension, selon le mode de réalisation préférentiel de l'invention.

Sur toutes les figures, les mêmes repères désignent les mêmes éléments.

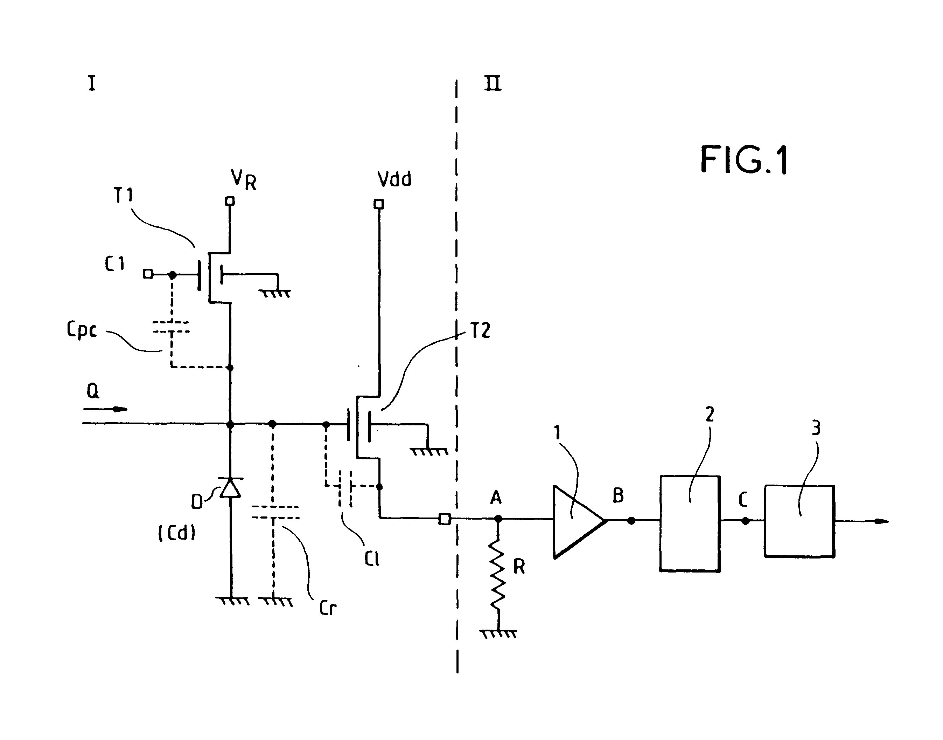

La figure 1 représente un convertisseur charge-tension et sa chaîne de lecture selon l'art antérieur.

La figure 1 est divisée en deux zones I et II.

Les circuits situés dans la zone I sont intégrés au composant qui génère les charges tel que, par exemple, un dispositif à transfert de charges. Les circuits situés dans la zone II sont des composants discrets extérieurs au composant qui génère les charges.

Le convertisseur charge-tension permet la conversion de la charge Q issue d'une grille de stockage (non représentée sur la figure) en une tension Vs. Cette tension Vs est recueillie en sortie A du dispositif à transfert de charge.

Comme cela a été mentionné précédemment, le convertisseur charge-tension est constitué d'une diode de lecture et d'un amplificateur de lecture.

L'amplificateur de lecture est réalisé par un transistor MOS T2 dont la grille est reliée à la diode de lecture D, le drain à une tension d'alimentation Vdd et la source au plot de sortie A du dispositif à transfert de charges.

Le gain du convertisseur est ajusté à l'aide d'une résistance R placée entre le plot de sortie A et le point de masse du circuit.

Comme cela est connu de l'homme de l'art, un transistor MOS T1 effectue, sous l'effet de la commande C1 appliquée à sa grille, une pré-charge de la capacité Cd de la diode D avant l'arrivée de la charge Q. Ce transistor dont le drain est relié à une tension d'alimentation Vr a sa source reliée à la fois au point d'arrivée de la charge Q, à la cathode de la diode D et à la grille du transistor T2.

La chaîne de lecture extérieure au dispositif à transfert de charges est constituée d'un amplificateur 1 de grand gain dont l'entrée est reliée au plot de sortie A, d'un filtre passe-bas 2 dont l'entrée est reliée à la sortie de l'amplificateur 1 et d'un échantillonneur double corrélé 3 dont l'entrée est reliée à la sortie du filtre 2.

Le filtre passe-bas 2 et l'échantillonneur 3 ne sont pas toujours présents dans la chaîne de lecture extérieure. Ils sont cependant nécessaires dans les applications à très basses fréquences.

Comme cela a été mentionné précédemment, l'étage de conversion présente un très mauvais gain. Sa valeur usuelle est la moitié de celle du gain à vide Go, laquelle peut être, par exemple, de l'ordre de 0,85.

Le bruit de la chaîne de lecture présente alors des performances médiocres puisque l'essentiel de l'amplification s'effectue après l'amplificateur de lecture. Ceci est très pénalisant, en particulier pour les applications traitant des signaux de faible amplitude.

Sur la figure 1 ont été représentées, en pointillés, les capacités parasites $C_r$, $C_l$, $C_{pc}$ des différents composants.

La capacité $C_r$ représente toutes les capacités de recouvrement environnantes à la diode D. La capacité $C_l$ représente la capacité grille-source du transistor T2. La capacité Miller ramenée à l'entrée de l'amplificateur de lecture de gain G s'écrit alors $C_m = C_l(1 - G)$. La capacité Cpc est la capacité grille-source du transistor T1. L'existence des capacités parasites $C_r$ et $C_m$ détériorent le facteur de conversion Fc. Comme cela sera décrit ultérieurement, l'invention permet avantageusement de prendre en compte l'influence des capacités parasites.

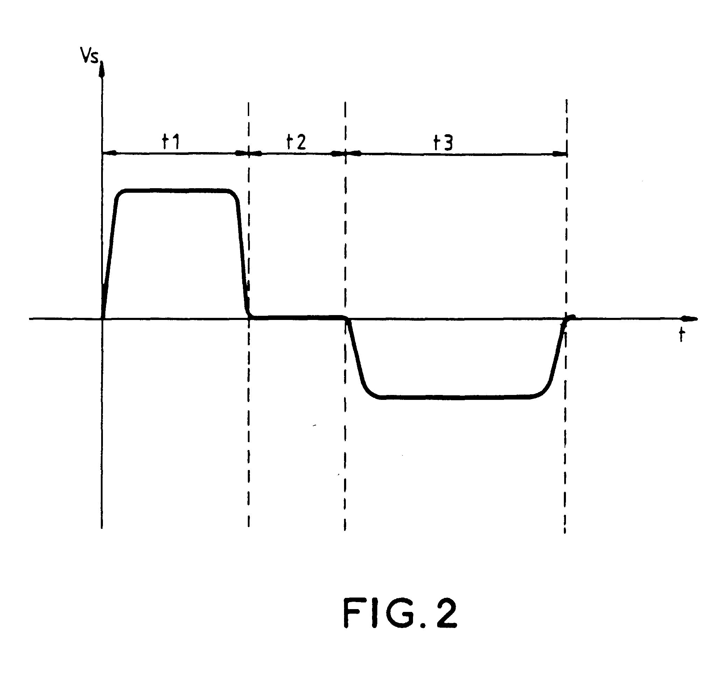

La figure 2 représente la tension Vs détectée, selon l'art antérieur, par le convertisseur charge-tension en fonction du temps.

Il est possible de définir trois intervalles de temps lors d'une conversion charge-tension. Ces intervalles de temps sont référencés t1, t2, t3 sur la figure 2.

L'intervalle t1 représente la durée de pré-charge de la capacité Cd de la diode D. Le transistor T1 est alors passant. La tension $V_s$ recueillie durant l'intervalle t1 est la tension recueillie en sortie de l'amplificateur de lecture.

Durant l'intervalle t2, la diode est à un potentiel flottant et le passage des charges est autorisé.

Enfin, durant l'intervalle t3, le signal utile issu de la conversion charge-tension est lu. Selon l'art antérieur, la chaîne de lecture amplifie le signal qui apparaît sur la grille du transistor T2 lors des trois intervalles de temps t1, t2 et t3.

Ainsi durant l'intervalle t1, la tension détectée peut-elle arriver à saturation si le gain de la chaîne est élevé.

Du fait du temps de relaxation propre aux différents circuits qui composent l'amplification de la chaîne de lecture, un niveau de bruit élevé demeure alors durant les intervalles t2 et t3. Il est alors nécessaire soit de limiter le gain de la chaîne afin d'éviter le phénomène de saturation, mais alors le signal utile se trouve atténué d'autant, soit de supprimer la tension d'alimentation des différents amplificateurs pendant l'intervalle t3 afin qu'il n'y ait plus d'amplification, mais alors des circuits complémentaires sont nécessaires.

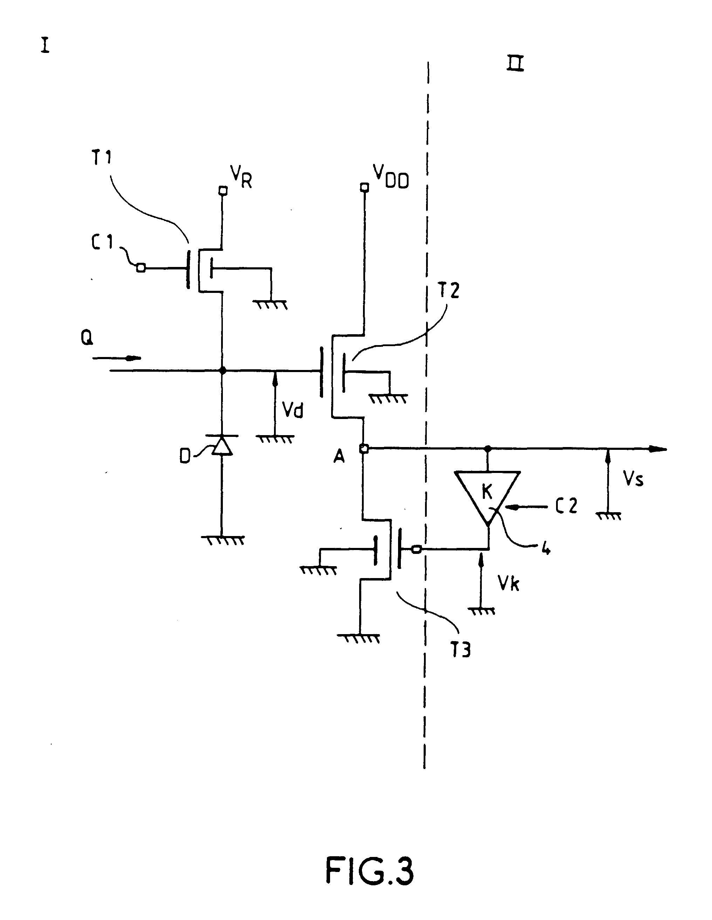

La figure 3 représente un convertisseur charge-tension selon le mode de réalisation préférentiel de l'invention. Comme sur la figure 1, la figure 3 est divisée en deux zones. Les circuits situés dans la zone I sont intégrés au composant qui génère les charges et les circuits situés dans la zone II sont des composants discrets extérieurs au composant qui génère les charges. Cependant, l'invention concerne aussi un autre mode de réalisation dans lequel les circuits situés dans la zone II sont eux aussi intégrés au composant qui génère les charges.

Le transistor T1, la diode D et le transistor T2 sont reliés comme indiqué précédemment.

Un transistor MOS T3, intégré au composant qui génère les charges, a son drain relié à la source du transistor T2 et sa source reliée à la masse du dispositif. Un amplificateur 4 de gain K, préférentiellement constitué d'un composant discret extérieur au dispositif, a son entrée reliée à la source du transistor T2 et sa sortie à la grille du transistor T3.

Comme dans l'art antérieur, le plot de sortie A du dispositif à transfert de charges est relié à la source du transistor T2 et à une chaîne d'amplification extérieure non représentée sur la figure.

Le transistor de lecture T2 fournit un gain à vide Go positif. Le transistor T3 a un comportement inverseur. Il agit comme une source de courant dont la valeur est avantageusement ajustée par la tension appliquée sur sa grille. Ainsi la dynamique de la tension de sortie Vs peut-elle être ajustée au mieux. Le transistor T3 monté en inverseur a un gain à vide égal à moins G1, G1 étant une quantité positive. La tension Vd étant la tension prise aux bornes de la diode D et la tension Vk celle prise en sortie de l'amplificateur 4 de gain K, il vient :

$$Vk = K \, Vs \text{ et } Vs = Go \, Vd - G1 \, Vk$$

donc :

$$Vs = \frac{Go}{1 + G_1 K} \, Vd$$

le gain de l'amplificateur de lecture selon l'invention est alors :

$$G = \frac{Go}{1 + G_1 K}$$

De façon préférentielle, les transistors T2 et T3 sont identiques. Ainsi $G_1$ et Go sont-ils égaux.

Selon l'invention, le gain K de l'amplificateur 4 varie selon l'intervalle de temps durant lequel s'effectue la conversion. L'amplificateur 4 contient des circuits, qu'il est inutile de préciser ici, et qui permettent de faire varier le gain K sous l'effet d'une commande C2.

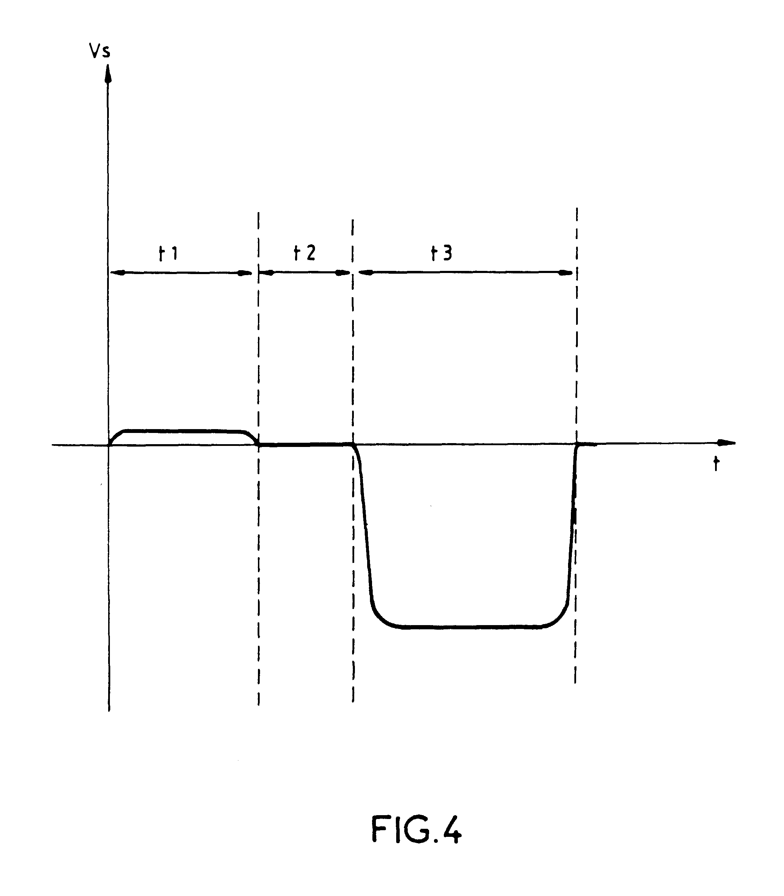

La figure 4 représente la tension détectée en fonction du temps par le convertisseur charge-tension, selon le mode de réalisation préférentiel de l'invention.

Durant l'intervalle t1, le gain K de l'amplificateur 4 prend une valeur positive élevée, par exemple K = 10. Le gain G prend alors sensiblement la valeur $\frac{1}{K}$. Cette valeur est sensiblement égale a zéro. La tension Vs détectée sur le plot de sortie A du convertisseur est donc elle aussi très faible.

En conséquence, l'amplification de la chaîne de lecture ne se trouve plus devoir être limitée comme dans l'art antérieur.

Durant les intervalles t2 et t3, le gain K prend une valeur négative faible de façon à assurer un gain G supérieur au gain Go. Préférentiellement G est supérieur à 1. La valeur de K peut, par exemple, être de l'ordre de moins 0,2. La valeur Vs détectée est alors avantageusement d'un niveau plus élevée que dans l'art antérieur.

Comme cela a été montré précédemment, le facteur de conversion s'écrit :

$$F_c = \frac{G}{C_d + C_r + C_m}$$

avec Cm = (1 - G) Cl

Il vient donc :

$$F_c = \frac{G}{C_d + C_r + (1-G)C1}$$

Ainsi, le facteur de conversion se trouve-t-il amélioré non seulement par l'accroissement du gain G, mais aussi par l'influence prise, selon l'invention, par la capacité Miller Cm. Pour les valeurs de G comprises entre Go et 1, Cm est diminuée. Pour G = 1, Cm est annulée. Enfin, pour G supérieur à 1, Cm prend des valeurs négatives permettant de compenser l'influence des capacités Cd et Cr.

Un avantage de l'invention est alors d'utiliser la capacité Miller Cm afin d'augmenter le facteur de conversion.

Selon l'art antérieur, l'influence de la capacité Miller diminue le facteur de conversion. Il est donc nécessaire de diminuer la valeur prise par cette capacité. Comme cela est connu de l'homme de l'art, le transistor T2 doit alors être de faibles dimensions. Il s'en suit une détérioration de la linéarité du potentiel en volume appliqué sous la grille de commande du transistor, laquelle détérioration entraîne une diminution de dynamique de la tension Vs recueillie.

l'invention ne présente pas cet inconvénient.

Un autre avantage de l'invention est alors de pouvoir réaliser un transistor de lecture T2 dont la capacité grille source Cl est plus élevée que la capacité grille source d'un transistor de lecture selon l'art antérieur. Les dimensions d'un tel transistor peuvent alors être supérieures aux dimensions d'un transistor selon l'art antérieur, entraînant par là même l'amélioration de la dynamique de la tension de sortie Vs.

**Revendications**

1. Dispositif de conversion charge-tension comprenant une diode de lecture (D) aux bornes de laquelle apparaît la tension Vd et un transistor de lecture (T2), de gain à vide Go, dont la grille est reliée à la diode de lecture de façon que soit appliquée à ladite grille ladite tension Vd et dont la source constitue le point (A) où est recueillie la tension de sortie Vs dudit dispositif, ladite conversion s'effectuant en trois temps, un premier temps (t1) durant lequel est effectué la pré-charge de la capacité (Cd) de la diode (D), un deuxième temps ($t_2$) durant lequel la diode est à un potentiel flottant et un troisième temps ($t_3$) pendant lequel le signal issu de la conversion charge-tension est lu, caractérisé en ce qu'il comprend un amplificateur (4) à gain contrôlé K, et un transistor (T3) monté en inverseur, de gain à vide égal à -G1, ledit amplificateur de gain K ayant son entrée reliée au point (A) où est recueillie la tension de sortie Vs et sa sortie reliée à la grille du transistor (T3) monté en inverseur, ce dernier ayant son drain relié à l'amplificateur de gain K et sa source reliée à une masse de façon que le gain G vérifie l'équation :

$$G = \frac{Go}{1+G1K},$$

l'amplificateur de gain K étant associé à des circuits de commande de gain permettant au gain K de prendre une valeur négative pendant les deuxième et troisième temps (t2, t3) de façon que le gain G soit supérieur à Go, et une valeur positive durant le premier temps (t1) de façon que le gain G soit sensiblement égal à zéro pendant ce premier temps.

2. Dispositif selon la revendication 1, caractérisé en ce que le transistor de lecture (T2) et le transistor monté en inverseur (T3) sont des transistors MOS.

3. Dispositif selon la revendication 2, caractérisé en ce que le transistor de lecture (T2) et le transistor monté en inverseur (T3) sont identiques de façon que $G_1$ soit égal à Go.

4. Dispositif selon la revendication 3, caractérisé en ce que Go est sensiblement égal à 0,85, K est sensiblement égal à - 0,2 pendant les deuxième et troisième temps (t2, t3) et, sensiblement égal à 10 pendant le premier temps (t1).

5. Dispositif à transfert de charges, caractérisé en ce qu'il comprend un dispositif selon l'une quelconque des revendications précédentes.

**Patentansprüche**

1. Vorrichtung zur Ladungs-Spannungsumwandlung mit einer Lesediode (D), an deren Klemmen die Spannung Vd auftritt, und mit einem Lesetransistor (T2), der einen Leerlaufverstärkungsgrads Go besitzt und dessen Gate an die Lesediode so angeschlossen ist, daß an dieses Gate die Spannung Vd gelangt, während die Source den Punkt (A) bildet, an dem die Ausgangsspannung Vs der Vorrichtung abgreifbar ist, wobei die Umwandlung in drei Zeitintervallen erfolgt, nämlich einem ersten Intervall (tl), während dem die Vor-Ladung der Kapazität ($C_d$) der Diode (D) erfolgt, einem zweiten Intervall (t2), während dem die Diode auf einem undefinierten Potential liegt, und einem dritten Intervall (t3), während dem das aus der Ladungs-Spannungsumwandlung stammende Signal gelesen wird, dadurch gekennzeichnet, daß ein Transistor (4) mit gesteuertem Verstärkungsgrad K und ein als Inverter geschaltete Transistor (T3) mit einem Leerlaufverstärkungsgrad von -$G_1$ vorgesehen sind, wobei der Eingang des Verstärkers mit dem Verstärkungsgrad K an den Punkt (A) angeschlossen ist, an dem die Ausgangsspannung Vs abgreifbar ist, während sein Ausgang an das Gate des als Inverter geschalteten Transistors (T3) angeschlossen ist, wobei der Drain dieses Transistors an den Verstärker mit dem Verstärkungsgrad K und seine Source an eine Masse angeschlossen ist, sodaß der Verstärkungsgrad G sich gemäß folgender Gleichung ergibt:

$$G = Go/(1+G_1 \cdot K),$$

und daß der Verstärker mit dem Verstärkungsgrad K mit Schaltungen zur Steuerung des Verstärkungsgrads versehen ist, mit denen der Verstärkungsgrad K während des zweiten und des dritten Zeitintervalls (t2, t3) einen negativen Wert annehmen kann, sodaß der Verstärkungsgrad G größer als Go wird, und einen positiven Wert während des ersten Zeitintervalls (tl) annehmen kann, sodaß während dieses ersten Zeitintervalls der Verstärkungsgrad G im wesentlichen null wird.

2. Vorrichtung nach Anspruch 1, dadurch gekennzeichnet, daß der Lesetransistor (T2) und der als Inverter geschaltete Transistor (T3) MOS-Transistoren sind.

3. Vorrichtung nach Anspruch 2, dadurch gekennzeichnet, daß der Lesetransistor (T2) und der als Inverter geschaltete Transistor (T3) einander gleichen, sodaß auch gilt: $G_1$ = Go.

4. Vorrichtung nach Anspruch 3, dadurch gekennzeichnet, daß Go im wesentlichen den Wert 0,85 besitzt und daß K während des zweiten und des dritten Intervalls (t2, t3) im wesentlichen den Wert -0,2 und während des ersten Intervalls (tl) im wesentlichen den Wert 10 hat.

5. Ladungstransfer-Vorrichtung, dadurch gekennzeichnet, daß sie eine Vorrichtung nach einem beliebigen der vorstehenden Ansprüche enthält.

## Claims

1. Charge-to-voltage converting device comprising a read diode (D) across the terminals of which the voltage Vd appears, and a read transistor (T2) having a no-load gain Go and whose gate is connected to said read diode in such a way that said voltage Vd is applied to said gate, and whose source is the point (A) at which the output voltage Vs of said device is collected, said conversion being carried out in three time intervals, a first interval (tl) during which the capacitance (Cd) of the diode (D) is precharged, a second interval (t2) during which the diode is at a floating potential, and a third interval (t3) during which the signal resulting from the charge-to-voltage conversion is read, characterised in that said device includes an amplifier (4) providing a controlled gain K, and a transistor (T3) connected as an inverter and providing a no-load gain equal to -G1, said amplifier providing gain K having its input connected to the point (A) at which the output voltage Vs is collected and its output connected to the gate of the transistor (T3) connected as an inverter, this transistor having its drain connected to the amplifier providing gain K and its source being earthed in such a way that the gain G is given by the equation:

$$G = \frac{Go}{1 + G1K},$$

   the amplifier providing gain K being associated with gain control circuits enabling the gain K to assume a negative value during the second and third intervals (t2, t3), so that the gain G becomes greater than Go, and a positive value during the first interval (tl) so that the gain G becomes substantially equal to zero during this first interval.

2. Device according to claim 1, characterised in that the read transistor (T2) and the transistor connected as an inverter (T3) are MOS transistors.

3. Device according to claim 2, characterised in that the read transistor (T2) and the transistor connected as an inverter (T3) are identical, such that $G_1$ is equal to Go.

4. Device according to claim 3, characterised in that Go is substantially equal to 0.85, K is substantially equal to -0.2 during the second and third intervals (t2, t3), and substantially equal to 10 during the first interval (t1).

5. Charge transfer device, characterised in that it includes a device according to any of the preceding claims.

FIG.1

EP 0 633 577 B1

FIG. 2

FIG.3

FIG.4